# DEMANDE DE BREVET EUROPEEN

(11) **EP 4 231 354 A1**
(43) Date de publication de la demande: **23.08.2023**
(21) Numéro de dépôt: 22209955.8
(22) Date de dépôt: 28.11.2022
(51) Int. Cl.: H01L 27/146, H10K 39/32, H10K 30/81

(54) **CAPTEUR D'IMAGES**

(30) Priorité: 18.02.2022 FR 2201456
(71) Demandeur: ISORG, 87068 Limoges Cedex 3 (FR)
(72) Inventeur: SARACCO, Emeline, 38000 GRENOBLE (FR); BOUTHINON, Benjamin, 38000 GRENOBLE (FR); FLAMEIN, François, 38000 GRENOBLE (FR)
(74) Mandataire: Cabinet Beaumont

(57) **Abrégé**

La présente description concerne un dispositif d'acquisition d'images (1), dans lequel des photodétecteurs (2) ont un motif suivant des lignes (14, 16) d'interconnexion de circuits de lecture (3) et des premières électrodes (27) des photodétecteurs (2) ont un motif en croix (57) dont deux branches sont respectivement à l'aplomb des lignes (14, 16) interconnectant les circuits de lecture (3).

## Description

### Domaine technique

La présente description concerne de façon générale les dispositifs d'acquisition d'images ou capteurs d'images, et vise plus particulièrement, les dispositifs d'acquisition d'images à base de photodétecteurs organiques.

### Technique antérieure

On a déjà proposé des dispositifs d'acquisition d'images comprenant une pluralité de photodétecteurs organiques, par exemple organisés en matrice. Dans certaines applications, le dispositif d'acquisition d'image est surmonté d'un écran d'affichage ou recouvre un écran d'affichage.

### Résumé de l'invention

Il existe un besoin d'amélioration des dispositifs d'acquisition d'images connus à base de photodétecteurs organiques.

Un mode de réalisation pallie tout ou partie des inconvénients des dispositifs d'acquisition d'images connus à base de photodétecteurs organiques.

Un mode de réalisation prévoit un dispositif d'acquisition d'images, dans lequel des photodétecteurs ont un motif suivant des lignes d'interconnexion de circuits de lecture.

Selon un mode de réalisation, des premières électrodes des photodétecteurs ont un motif en croix dont deux branches sont respectivement à l'aplomb des lignes interconnectant les circuits de lecture.

Selon un mode de réalisation, une couche d'injection de trous commune aux photodétecteurs a un motif de quadrillage à l'aplomb des lignes interconnectant les circuits de lecture.

Selon un mode de réalisation, une couche active de chaque photodétecteur a le motif de quadrillage de la couche d'injection de trous.

Selon un mode de réalisation, une couche active de chaque photodétecteur a le motif en croix de sa première électrode.

Selon un mode de réalisation, la couche active et la première électrode de chaque photodétecteur s'étendent au-delà dudit motif.

Selon un mode de réalisation, chaque circuit de lecture comporte un transistor, les lignes d'interconnexion correspondant à des lignes interconnectant respectivement les sources des transistors selon une première direction et les grilles des transistors selon une deuxième direction.

Selon un mode de réalisation, le motif selon lequel sont réalisés les photodétecteurs est également à l'aplomb de contacts de drain des transistors des circuits de lecture.

Selon un mode de réalisation, la surface masquée par la couche active des photodétecteurs représente, pour chaque pixel, moins de 50%, de préférence moins de 30% de la surface du pixel.

Un mode de réalisation et de mise en œuvre prévoit un procédé de fabrication d'un dispositif d'acquisition d'images comprenant les étapes suivantes :
formation d'une matrice de circuits de lecture dont des transistors sont interconnectés en lignes de sources dans une première direction et en lignes de grilles dans une deuxième direction ;
dépôt, à partir de la matrice de circuits de lecture, d'un empilement comportant au moins :
   une électrode ;
   une couche active ; et
   une couche injectrice de trous,
gravure des couches de l'empilement séparément ou simultanément selon un motif suivant au moins des lignes d'interconnexion de circuits de lecture.

Selon un mode de réalisation, la gravure des couches de l'empilement est telle que la surface masquée de façon cumulative par la couche d'électrode et la couche active représente, pour chaque pixel, moins de 50%, de préférence moins de 30% de la surface du pixel.

Selon un mode de réalisation, la couche active est gravée en même temps que la couche injectrice de trous.

Selon un mode de réalisation, un filtre optique est rapporté sur l'empilement.

Selon un mode de réalisation, les couches de l'empilement recouvrent en outre des contacts de drain des transistors des circuits de lecture.

Selon un mode de réalisation, les étapes du procédé sont adaptées à la fabrication d'un dispositif tel que décrit.

### Brève description des dessins

Ces caractéristiques et avantages, ainsi que d'autres, seront exposés en détail dans la description suivante de modes de réalisation et de mise en oeuvre particuliers faite à titre non limitatif en relation avec les figures jointes parmi lesquelles :
la figure 1 représente, de façon partielle et schématique, un schéma électrique d'un mode de réalisation d'un dispositif d'acquisition d'images ;
la figure 2 est une vue en coupe, partielle et schématique, d'un mode de réalisation d'un dispositif d'acquisition d'images ;
la figure 3 est une vue en perspective éclatée, partielle et schématique, d'un mode de réalisation d'un dispositif d'acquisition d'images ;
la figure 4A, la figure 4B et la figure 4C sont des vues schématiques de dessus, de couches du mode de réalisation d'un dispositif d'acquisition d'images de la figure 3 ;
la figure 5A, la figure 5B, la figure 5C, la figure 5D, la figure 5E, la figure 5F, la figure 5G, la figure 5H et la figure 5I sont des vues en coupe, partielles et schématiques, illustrant des étapes d'un mode de mise en œuvre d'un procédé de fabrication d'un dispositif d'acquisition d'images ;
la figure 6A et la figure 6B sont des vues en coupe, partielles et schématiques, illustrant des étapes d'un autre mode de mise en œuvre d'un procédé de fabrication d'un dispositif d'acquisition d'images ;
la figure 7A et la figure 7B sont des vues en coupe, partielles et schématiques, illustrant des étapes d'un autre mode de mise en œuvre d'un procédé de fabrication d'un dispositif d'acquisition d'images ;
la figure 8 est une vue en coupe, partielle et schématique, illustrant une variante de réalisation d'un dispositif d'acquisition d'images ; et
la figure 9 est une vue de dessus, partielle et schématique, illustrant une autre variante de réalisation d'un dispositif d'acquisition d'images.

### Description des modes de réalisation

De mêmes éléments ont été désignés par de mêmes références dans les différentes figures. En particulier, les éléments structurels et/ou fonctionnels communs aux différents modes de réalisation et de mise en œuvre peuvent présenter les mêmes références et peuvent disposer de propriétés structurelles, dimensionnelles et matérielles identiques.

Par souci de clarté, seuls les étapes et éléments utiles à la compréhension des modes de réalisation et de mise en œuvre décrits ont été représentés et sont détaillés. En particulier, la réalisation des circuits électroniques de contrôle et de lecture des photodétecteurs des dispositifs décrits n'a pas été détaillée. En outre, les diverses applications que peuvent avoir les dispositifs décrits n'ont pas été détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près ou à 10° près, de préférence à 5 % près ou à 5° près.

Dans la suite de la description, on appelle lumière visible un rayonnement électromagnétique dont la longueur d'onde est comprise entre 400 nm et 700 nm et on appelle rayonnement infrarouge un rayonnement électromagnétique dont la longueur d'onde est comprise entre 700 nm et 1 mm. Dans le rayonnement infrarouge, on distingue notamment le rayonnement infrarouge proche dont la longueur d'onde est comprise entre 700 nm et 1,7 µm.

Dans la suite de la description, une couche ou un film est dit transparent à un rayonnement lorsque la transmittance du rayonnement au travers de la couche ou du film est supérieure à 10 %, de préférence, supérieure à 50 %.

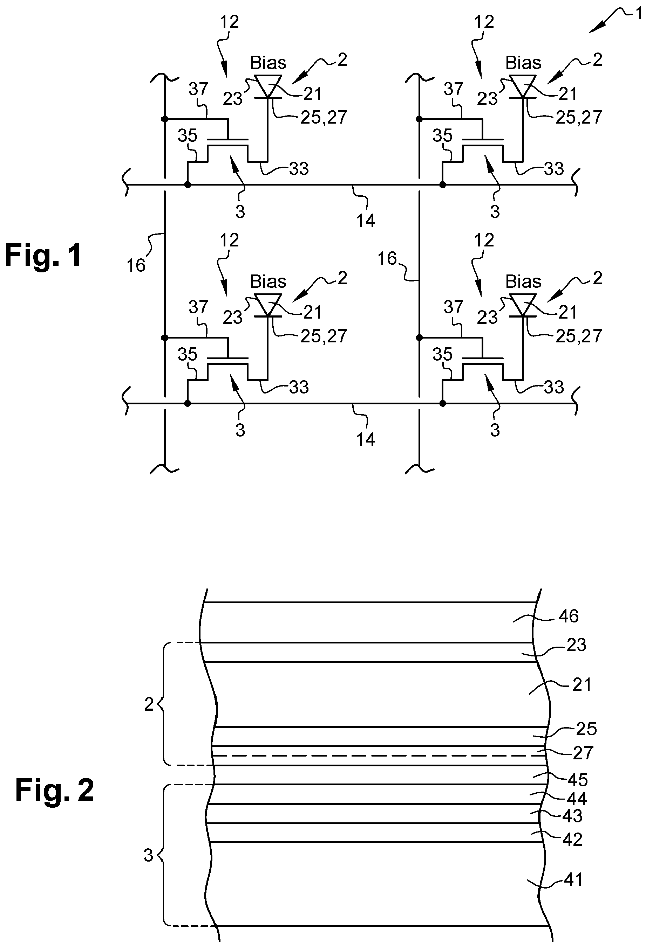

La figure 1 représente, de façon partielle et schématique, un schéma électrique d'un mode de réalisation d'un dispositif d'acquisition d'images 1.

Un rôle d'un dispositif d'acquisition d'images 1 est d'acquérir des images représentatives d'un rayonnement (visible et/ou infrarouge selon l'application).

Un dispositif d'acquisition d'images 1, ou capteur d'images, du type auquel s'appliquent les modes de réalisation et de mise en œuvre décrits, comporte une matrice de capteurs de photons, appelés photodétecteurs 2, chacun associé à un circuit de lecture 3. Quatre photodétecteurs et quatre circuits de lecture sont représentés en figure 1. En pratique, le dispositif d'acquisition d'images 1 comporte un grand nombre (par exemple plusieurs centaines à plusieurs millions) de photodétecteurs 2 et de circuits de lecture 3. Les photodétecteurs 2 sont par exemple identiques ou similaires (aux dispersions de fabrication près). De même, les circuits de lecture sont par exemple identiques ou similaires (aux dispersions de fabrication près).

De façon arbitraire, on désigne par « pixel » 12 du dispositif d'acquisition d'images 1, l'association d'un photodétecteur 2 et de son circuit de lecture 3. On notera toutefois que, selon l'application et l'organisation du dispositif d'acquisition d'images 1 ainsi que des autres dispositifs qui y sont associés tel qu'un écran d'affichage (non représenté), ce pixel 12 peut représenter un sous-pixel.

En figure 1, chaque photodétecteur 2 est symbolisé sous la forme d'une photodiode et chaque circuit de lecture 3 est symbolisé sous la forme d'un transistor. De préférence, les transistors sont des transistors en couches minces (TFT, de l'anglais « Thin-Film Transistors ») qui peuvent être réalisés sur un substrat transparent.

Chaque photodétecteur 2 comprend une couche active 21 entre une électrode ou couche injectrice de trous 23 (HIL, de l'anglais « Hole Injecting Layer »), symbolisée par l'anode de la photodiode en figure 1, une couche injectrice d'électrons 25 (EIL, de l'anglais « Electron Injecting Layer ») et une électrode 27, symbolisées par la cathode de la photodiode en figure 1. La couche active 21 est la couche qui capte le rayonnement photonique et qui restitue un signal électrique correspondant, via l'électrode 27 du photodétecteur 2, au circuit de lecture 3 du pixel 12 concerné. Les couches HIL et EIL facilitent la polarisation de la couche active. La couche HIL peut également servir d'électrode ou une électrode métallique peut être rapportée sur la couche HIL. La couche HIL est polarisée (Bias) directement ou via l'électrode qui lui est associée. Les photodétecteurs 2 sont des photodétecteurs organiques (OPD, de l'anglais « Organic PhotoDetector »), c'est-à-dire que les couches qui les constituent et notamment la couche active 21 est en un matériau semiconducteur organique (OSC, de l'anglais « Organic Semi-Conductor »).

Les circuits de lecture 3 sont réalisés dans un substrat (non représenté en figure 1) dans et/ou sur lequel sont formées les régions de canal des transistors, les régions de source et de drain, les régions de grille, ainsi que les reprises de contacts de ces régions. Dans l'exemple de la figure 1, on suppose que le drain 33 de chaque transistor constituant un circuit de lecture 3 est relié, de préférence connecté, à l'électrode 27 de cathode du photodétecteur 2 du pixel 12 concerné. Les sources 35 des transistors 3 des différents pixels 12 sont reliées, de préférence connectées, électriquement en lignes 14 (dans l'orientation de la figure 1). Les grilles 37 des transistors des différents pixels 12 sont reliées, de préférence connectées, électriquement en colonnes 16 (dans l'orientation de la figure 1). Les extrémités des lignes 14 et des colonnes 16 sont reliées à des circuits électroniques de commande et d'interprétation non représentés et qui sont en eux-mêmes usuels. Ces circuits électroniques sont par exemple également réalisés dans et/ou sur le substrat dans et/ou sur lequel sont formés les transistors des circuits de lecture 3. La polarisation de la couche HIL est apportée par ces circuits et est distribuée en périphérie de l'agencement matriciel. L'orientation des lignes 14 et des colonnes 16 est bien entendu arbitraire. Pour simplifier, on fera par la suite référence à des lignes de grilles 16 et à des lignes de sources 14. Les lignes 14 et 16 sont, de préférence, selon deux directions perpendiculaires.

La figure 2 est une vue en coupe, partielle et schématique, d'un mode de réalisation d'un dispositif d'acquisition d'images.

Dans l'exemple de la figure 2, le dispositif d'acquisition d'image est formé d'un empilement de couches de différentes natures, respectant pour chaque couche des motifs (« pattern » en anglais) déterminés pour respecter l'agencement matriciel de photodétecteurs 2 et de circuits de lecture 3.

L'empilement de couches comporte, par exemple, de bas en haut dans l'orientation de la figure 2 :
- le substrat 41, dans et/ou sur lequel sont formés les circuits de lecture, ou transistors, 3 ;
- une ou plusieurs couches conductrices ou semiconductrices 42 dans laquelle ou lesquelles sont formés les contacts de source 35 et de drain 33 des transistors 3 ainsi que les lignes 14 de reprise des contacts de source ;
- une ou plusieurs couches diélectriques (isolantes) 43 dans laquelle ou lesquelles sont formés les isolants de grille des transistors 3 et qui, généralement, isolent latéralement les uns des autres les motifs réalisés dans la couche 42 ;
- une ou plusieurs couches conductrices ou semiconductrices 44 dans laquelle ou lesquelles sont formés les contacts de grille 37 des transistors ainsi que les lignes 16 de reprise des contacts de grille ;
- une ou plusieurs couches diélectriques (isolantes) 45 séparant la matrice de circuits de lecture 3 de la matrice de photodétecteurs 2 et qui, généralement, isolent latéralement les uns des autres les motifs réalisés dans la couche 44 ;
- un ou plusieurs couches constituant l'électrode 27 ;
- la couche injectrice d'électrons 25 (EIL) ;
- la couche active 21 ;
- la couche injectrice de trous 23 (HIL).

La couche HIL 23 est généralement recouverte d'une couche de planarisation et d'une couche de protection ou couche barrière, symbolisées par une couche 46 en figure 2.

Enfin, d'autre couches ou niveaux non représentés peuvent être associées au dispositif d'acquisition d'images. Il s'agit par exemple :
- d'un ou plusieurs filtres optiques ne laissant passer que certaines longueurs d'ondes dans le visible et/ou l'infrarouge qui atteignent la couche HIL 23 ;
- d'un écran d'affichage ;
- d'une interface tactile ; et
- plus généralement, de tout élément usuel selon l'application concernée.

Parmi les couches constitutives du dispositif d'acquisition d'images, certaines sont opaques et d'autres sont plus ou moins transparentes.

Dans certaines applications, on souhaite associer le dispositif d'acquisition d'image à un écran d'affichage ou l'intégrer dans un dispositif d'affichage.

Un exemple d'application concerne le contrôle d'affichage, c'est-à-dire une utilisation du dispositif d'acquisition d'images pour contrôler le contenu d'un affichage sur un écran. Dans ce cas, le rayonnement que capte le dispositif d'acquisition d'images est le rayonnement de l'écran d'affichage. Le dispositif d'acquisition d'images se trouve alors entre l'écran et l'utilisateur visionnant l'écran. Le dispositif d'affichage peut être opaque, voire lui-même transparent (par exemple un écran d'affichage intégré dans une vitre ou un afficheur « tête-haute » d'un véhicule automobile). L'écran d'affichage se trouve, dans l'empilement de la figure 2, au-dessus des couches 46.

Un autre exemple d'application concerne les dispositifs d'acquisition d'images devant un écran d'affichage, le capteur d'images étant orienté pour capter les images qui sont devant l'écran qui est alors transparent ou non. L'écran d'affichage se trouve, dans l'empilement de la figure 2, par exemple, en-dessous du substrat 41 ou entre la matrice de circuits de lecture 3 et la matrice de photodétecteurs 2.

Dans ce genre d'applications, il est souhaitable que le dispositif d'acquisition d'images soit le plus transparent possible dans le visible afin de ne pas gêner la perception de l'affichage par l'utilisateur.

Or, parmi les couches utilisées pour réaliser le capteur d'images, certaines sont plus ou moins transparentes et d'autres sont opaques dans le visible.

En particulier, les matériaux généralement utilisés pour le photodétecteur et notamment celui ou ceux des couches 27 (électrode) et 21 (OSC) ne sont pas transparents.

Quand bien même certaines couches sont transparentes à hauteur de 10%, voire 50%, la superposition des différentes couches conduit à un empilement quasi-opaque.

Par ailleurs en prenant l'exemple des dispositifs d'acquisition d'images utilisés pour capter dans l'infrarouge, ces capteurs sont équipés de filtres optiques qui coupent le rayonnement visible.

Dans les dispositifs usuels d'acquisition d'images, on cherche généralement à maximiser la surface occupée par les photodétecteurs pour accroitre la sensibilité. Cependant, dans les applications visées, les dimensions des pixels du dispositif d'acquisition d'images sont liées à celles de l'écran d'affichage auquel le dispositif est associé, ce qui permet de conserver une sensibilité acceptable en réduisant la surface occupée par les photodétecteurs.

Par ailleurs, dans les applications visées, les dimensions des pixels 12, correspondant au pas des lignes de grilles 16 dans une direction et à celui des lignes de sources 14 dans l'autre direction, sont élevées par rapport à la taille des circuits de lecture 3.

Selon les modes de réalisation et de mise en œuvre décrits, on prévoit de tirer profit de la présence de couches opaques (par exemple, métalliques) au niveau des circuits de lecture 3 pour réaliser tout ou partie des couches du photodétecteur approximativement selon le même motif que les couches opaques de ces circuits de lecture.

En d'autres termes, on prévoit de concentrer les photodétecteurs 2 à l'aplomb des circuits de lecture 3 afin de maximiser la proportion surfacique du pixel, libre de couches opaques. Cette répartition permet d'ajuster les dimensions entre les zones photosensibles (entre les photodétecteurs) en fonction des performances souhaitées, entre autres, en termes de sensibilité, de résolution et de transparence. En effet, les dimensions des circuits de lecture 3 ne dépendent pas de la taille des photodétecteurs 2 mais du pas de ces photodétecteurs. Cela permet de faire varier, en fonction de la taille souhaitée pour les pixels 12, le taux de transparence du pixel.

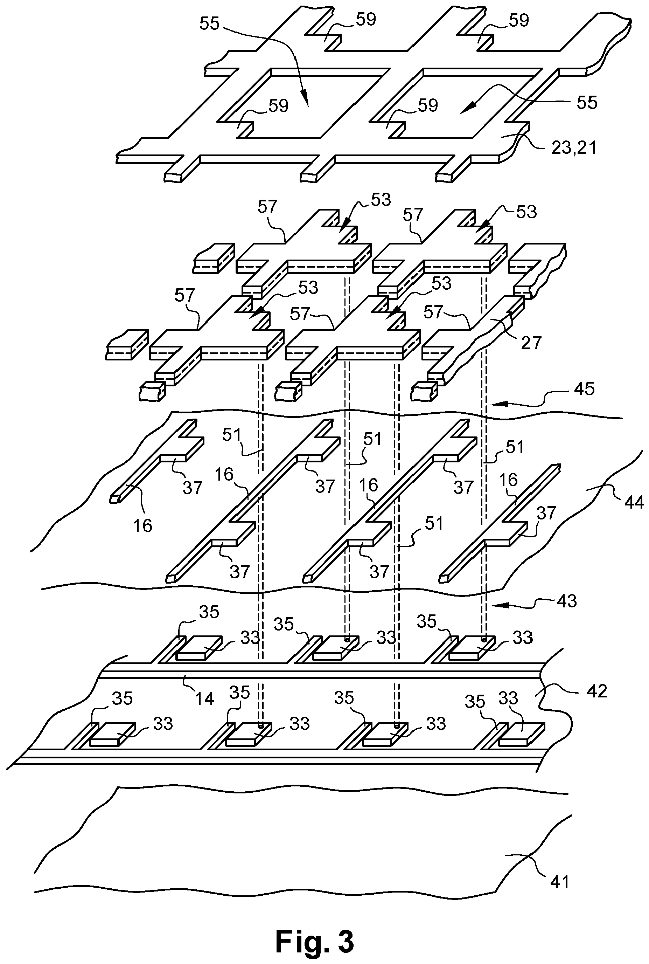

La figure 3 est une vue en perspective éclatée, partielle et schématique, d'un mode de réalisation d'un dispositif d'acquisition d'images.

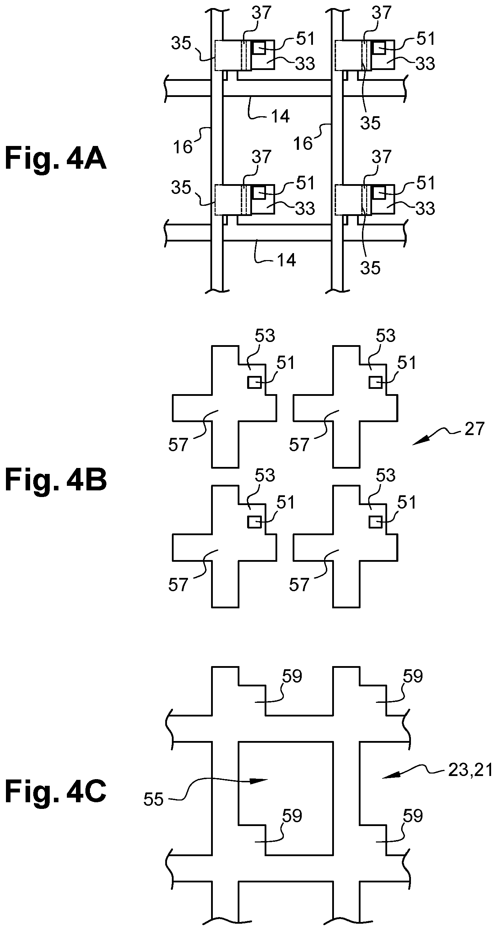

Les figures 4A, 4B et 4C sont des vues schématiques de dessus, de couches du mode de réalisation d'un dispositif d'acquisition d'images de la figure 3.

La figure 3 représente, en perspective, l'empilement et les motifs respectifs de couches constitutives du dispositif d'acquisition d'images. Toutes les couches ne sont pas représentées. En particulier, les couches isolantes 43 et 45 qui séparent les niveaux conducteurs 42 et 44, respectivement 44 et 27, ne sont pas représentées en figure 3, ces couches pouvant aisément être dans des matériaux ayant une transparence supérieure à 70% au passage de la lumière dans le domaine visible. La couche EIL 25 n'est également pas représentée en figure 3, cette couche pouvant être localisée ou non.

Les figures 4A, 4B et 4C sont des vues de dessus correspondant à la figure 3 et illustrant respectivement les motifs :
des couches conductrices (par exemple métalliques) de contacts de source et de drain et de lignes de sources, ainsi que de contact de grille et de lignes de grilles ;
de la d'électrode 27 des photodétecteurs ; et
des couches active 21 et HIL 23.

Les motifs des différentes couches illustrées en figures 3 et 4 respectent l'organisation matricielle du dispositif d'acquisition d'images tel que représenté en figure 1.

On retrouve, de bas en haut dans l'orientation de la figure 3 :
- le substrat 41 dans lequel sont réalisés les transistors des circuits de lecture 3, ainsi que, le cas échéant, d'autres circuits semiconducteurs associés à la commande des circuits de lecture et à l'interprétation des signaux électriques extraits des photodétecteurs ;
- la ou les couches conductrices ou semiconductrices 42 dans laquelle ou lesquelles sont formés les contacts de source 35 et de drain 33 des transistors 3 ainsi que les lignes de sources 14 de reprise des contacts de source ;
- la ou les couches diélectriques (isolantes) 43 ;
- la ou les couches conductrices ou semiconductrices 44 dans laquelle ou lesquelles sont formés les contacts de grille 37 des transistors ainsi que les lignes de grilles 16 de reprise des contacts de grille ;
- la ou les couches diélectriques (isolantes) 45 ;
- la couche d'électrode 27 ; et
- un empilement, dans ce mode de réalisation selon le même motif, constitué de la couche active 21 (OSC) et de la couche injectrice de trous 23 (HIL). Cet empilement comprend le cas échéant également la couche injectrice d'électrons 25 (EIL) non représentée aux figures 3 et 4.

Les liaisons électriques verticales respectives, entre les drains 33 des transistors et les électrodes 27 des photodétecteurs, sont assurées par des vias conducteurs verticaux 51 reliant, de préférence connectant, les couches 42 et 27. Le tracé d'au moins la couche 27 parmi les couches 27, 25 et 21, de préférence le tracé des deux couches 27 et 21, est tel que chaque électrode 27 comporte une zone 53 à l'aplomb du contact de drain 33 du transistor 3 du pixel concerné. Non seulement, cela maximise la surface du photodétecteur sans nuire à la transparence du pixel (le contact de drain 33 étant de toute façon opaque) mais cela permet de localiser aisément les vias 51.

Une particularité des pixels de la structure représentée en figures 3 et 4 est que les couches 23, 21, 25 et 27, constitutives des photodétecteurs 2, sont formées en fonction des motifs des couches conductrices 42 et 44. En d'autres termes, sachant que les couches conductrices 42 et 44 sont en des matériaux opaques, on choisit le tracé des couches des photodétecteurs 2 pour que leurs couches suivent le tracé des couches 42 et 44. Ainsi, comme les dimensions des pixels 12 sont importantes devant les dimensions des circuits de lecture 3, on préserve des zones transparentes 55 de dimensions importantes dans la surface du dispositif d'acquisition d'image. Ces zones 55 sont en outre présentes au niveau de chaque pixel 12, de sorte que l'affichage réalisé par un écran d'affichage (non représenté) est préservé.

Ainsi, dans l'exemple des figures 3 et 4, les motifs formés dans la couche 27 représentent des croix 57 dont les deux branches sont respectivement parallèles aux lignes de sources 14 et aux lignes de grilles 16 et dont l'intersection se situe approximativement à l'aplomb des zones de chevauchement entre les lignes de sources et les lignes de grilles. Chaque croix 57 comporte une excroissance latérale formant la zone 53. Les croix 57 sont séparées les unes des autres dans la mesure où elles définissent des photodétecteurs de pixels différents. Les branches d'une croix 57 donnée sont séparées des branches des quatre croix 57 avec lesquelles elles sont alignées par un intervalle ou écart qui sera comblé ultérieurement par un matériau isolant ou semiconducteur (non représenté en figure 3).

Les couches active 21 et HIL 23 peuvent être communes aux différents pixels et n'ont pas besoin de respecter le motif en croix disjointes 57 de la couche 27. L'électrode que constitue la couche 23 est même préférentiellement commune à tous les photodétecteurs du dispositif d'acquisition d'images. La couche active 21 étant généralement en des matériaux opaques, elle est cependant réalisée selon un quadrillage dont les deux directions sont respectivement alignées avec les lignes de sources 14 et les lignes de grilles 16. Les couches active 21 et HIL 23 comportent également de préférence des zones 59 à l'aplomb des zones 33.

En variante, la couche active 21 respecte le tracé en croix 57 (plus de l'excroissance 53) de la couche d'électrode 27. Le couche HIL reste cependant commune à tous les pixels. EN particulier, si elle est transparente, elle peut ne pas être gravée et rester commune à tout le dispositif d'acquisition.

Dans le cas où les couches 21 et 23 sont gravées en même temps, les largeurs des lignes du quadrillage des couches active 21 et HIL 23 sont de préférence identiques ou supérieures à celles des branches des croix 57. Les largeurs des branches des croix 57 sont choisies pour être, de préférence, au moins égales aux largeurs respectives des lignes de sources 14 et des lignes de grilles 16 à l'aplomb desquelles elles se trouvent de façon à profiter du maximum de surface opaque déjà imposé par ces lignes de sources et de grilles. Les largeurs des branches sont choisies en fonction de la transparence et des sensibilité et résolution souhaitées. Ce choix s'effectue préférentiellement en faisant un compromis entre ces deux critères. Les branches des croix 57 peuvent donc être plus larges que les lignes de sources et les lignes de grilles. L'écart entre les croix dans les directions des lignes de sources et de grilles est, au minimum, d'une valeur permettant l'isolation électrique entre les électrodes 27 de pixels voisins.

Les largeurs des lignes des couches active 21 et HIL 23 sont choisies pour être, par exemple, approximativement égales, de préférence supérieures, aux largeurs des branches des croix 57.

Les dimensions des zones 53 et 59 sont choisies en fonction des dimensions des contacts de drain 33. Par exemple, les dimensions des zones 53 et 59 sont au moins égales, de préférence approximativement égales, aux dimensions des contacts de drain 33 de façon à profiter du maximum de surface opaque déjà imposé par ces lignes de sources et de grilles. En pratique, elles pourront mêmes être de dimensions supérieures à celles des contacts de drain 33.

La transparence peut être définie, au niveau d'un pixel 12, par le rapport de la surface de la zone 55 sur la surface du pixel.

Dans l'exemple de la figure 3, on suppose que les transistors 3 sont des transistors horizontaux, c'est-à-dire dont les régions de source et de drain sont sensiblement coplanaires, par opposition à des transistors verticaux où les régions de source et de drain sont alignées verticalement.

Les modes de réalisation et de mise en œuvre décrits se transposent néanmoins à des réalisations de circuits de lecture à base de transistors verticaux, pourvu que les zones opaques constituées par les niveaux conducteurs occupent, comme pour les structures latérales ou horizontales, une surface faible par rapport à la surface du pixel.

A titre d'exemple particulier de réalisation, pour des pixels 12 ayant des dimensions de l'ordre de 50 µm, donc un pas de l'ordre de 50 µm dans les deux directions du plan, on peut prévoir une largeur de branches de l'ordre de 10 µm. Par ailleurs, on peut prévoir des zones 53 et 59 carrées ayant des côtés de l'ordre de 10 µm. Avec de telles proportion, la transparence obtenue est de l'ordre de 70%.

Un avantage de l'architecture décrite est qu'elle permet d'améliorer la transparence globale du dispositif d'acquisition d'images sans nuire à sa sensibilité ni à la résolution.

Un autre avantage est que la transparence est directement liée au facteur de remplissage des pixels par des couches opaques. Cela facilite la détermination du compromis entre la transparence et les sensibilité et résolution.

Le tableau 1 ci-dessous donne des exemples de transparence pour plusieurs valeurs de pas des pixels, en supposant que les branches des croix 57 recouvrent sans débord les lignes de grilles 16 et les lignes de sources 14 qui ont des largeurs de l'ordre de 10 µm et en supposant des contacts de drain 33 de 30 µm par 40 µm.

**[Table 1]**

| Pas | Facteur de remplissage / transparence |
|---|---|
| 50 µm | 12% |
| 85 µm | 60% |
| 100 µm | 68% |
| 105 µm | 70% |
| 125 µm | 76% |
| 300 µm | 92% |

À titre d'exemple, l'électrode 27 correspond à une ou des couches électriquement conductrices opaque et/ou transparente faite :
en un oxyde conducteur transparent (TCO, de l'anglais « Transparent Conductive Oxide »), par exemple l'oxyde de zinc dopé en gallium, l'oxyde d'étain, l'oxyde d'étain dopé au fluor (FTO, de l'anglais « Fluorine doped Tin Oxide »), l'oxyde de zinc, l'oxyde de zinc dopé en aluminium, l'oxyde de cadmium dopé à l'indium, le nitrure de titane TiN, l'oxyde d'indium-étain (ITO, Indium Tin Oxide), etc. ;
en un métal, par exemple, l'or, l'argent, le plomb, le palladium, le cuivre, le nickel, le tungstène ou le chrome ;
en nanofils de carbone, d'argent ou de cuivre ;
en graphène ; ou
en un mélange de deux ou plus de ces matériaux.

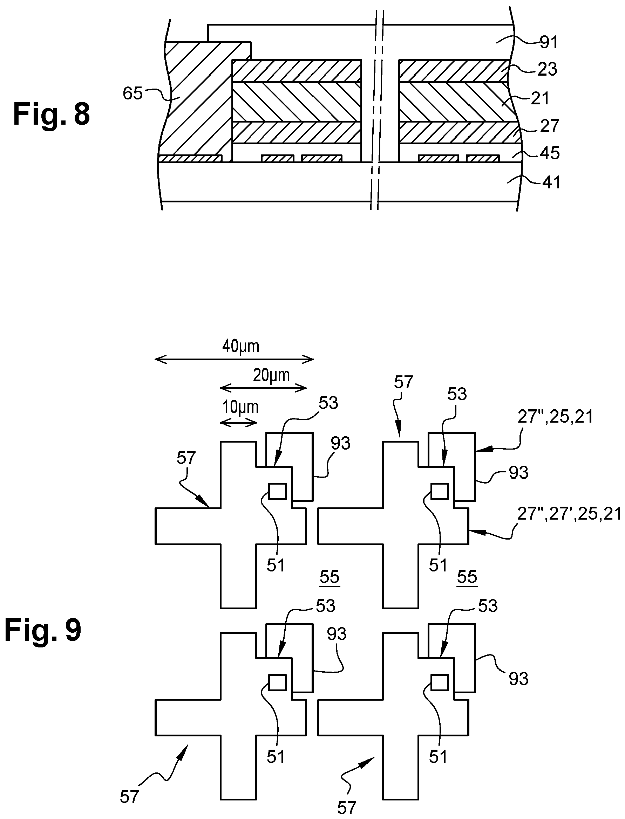

De préférence, l'électrode 27 est constituée d'une couche métallique et d'une couche en oxyde conducteur transparent (par exemple en ITO). La couche d'ITO recouvre la couche métallique et est en contact avec celle-ci. Dans ce cas, la couche d'ITO peut avoir le même motif que la couche active 21 et s'étendre dans les zones 55 de chaque pixel comme on le verra en relation avec la figure 9, pourvu d'être localisée par pixel. De préférence, la couche métallique de l'électrode 27 est alors de dimensions inférieures et respecte quant à elle le motif des figure 3 et 4.

À titre d'exemple, la couche EIL 25 recouvre l'électrode 27, plus particulièrement la couche en ITO de cette électrode, et est en contact avec celle-ci.

À titre d'exemple, la couche EIL 25 est en un matériau polymère. La couche EIL 25 est par exemple obtenue à partir d'une encre comportant un polymère en solution dans un solvant. Le polymère de la couche EIL 25 est, par exemple, un polyéthylène imine (PEI) ou un polyéthylène imine éthoxylé (PEIE) .

Selon un autre exemple, la couche EIL est choisie parmi le groupe comportant :
- un oxyde métallique, notamment un oxyde de titane ou un oxyde de zinc ;
- un système hôte/dopant moléculaire, notamment les produits commercialisés par la société Novaled sous les appellations NET-5/NDN-1 ou NET-8/MDN-26 ;
- un polymère conducteur ou semiconducteur dopé, par exemple le polymère PEDOT:Tosylate qui est un mélange de poly(3,4)-éthylènedioxythiophène et de tosylate ;
- le polyéthylèneimine (PEI) ou le polyéthylèneimine éthoxylée (PEIE), propoxylée et/ou butoxylée ;
- un carbonate, par exemple du CsCO3 ;
- un polyélectrolyte, par exemple du poly[9,9-bis(3'-(N,N-diméthylamino)propyl)-2,7-fluorène-alt-2,7-(9,9-dioctyfluorène)] (PFN), du poly[3-(6-triméthylammoniumhexyl)thiophène] (P3TMAHT) ou du poly[9,9-bis(2-éthylhexyl)fluorène]-b-poly[3-(6-triméthylammoniumhexyl] thiophène (PF2/6-b-P3TMAHT) ; et
- un mélange de deux ou de plus de deux de ces matériaux.

À titre d'exemple, la couche active 21 recouvre la couche EIL 25 et est en contact avec celle-ci.

À titre d'exemple, la couche active 21 est en un matériau semiconducteur organique (OSC) par exemple déposé par voie liquide. La couche active 21 peut comprendre un matériau semiconducteur ambipolaire, ou un mélange d'un matériau semiconducteur de type N et d'un matériau semiconducteur de type P, par exemple sous forme de couches superposées ou d'un mélange intime à l'échelle nanométrique de façon à former une hétérojonction en volume. L'épaisseur de la couche active 21 peut être comprise entre 50 nm et 2 µm, par exemple de l'ordre de 200 nm. Des exemples de polymères semiconducteurs de type adaptés à la réalisation de la couche active 21 sont le poly(3-hexylthiophène) (P3HT), le poly[N-9'-heptadécanyl-2,7-carbazole-alt-5,5-(4,7-di-2-thiényl-2',1',3'-benzothiadiazole)] (PCDTBT), le poly[(4,8-bis-(2-éthylhexyloxy)-benzo[1,2-b;4,5-b'] dithiophène)-2,6-diyl-alt-(4-(2-éthylhexanoyl)-thieno[3,4-b] thiophène))-2,6-diyl] (PBDTTT-C), le poly[2-méthoxy-5-(2-éthyl-hexyloxy)-1,4-phénylène-vinylène] (MEH-PPV) ou le poly[2,6-(4,4-bis-(2-éthylhexyl)-4H-cyclopenta [2,1-*b*;3,4-*b*']dithiophène)-alt-4,7(2,1,3-benzothiadiazole)] (PCPDTBT). Des exemples de matériaux semiconducteurs de type N adaptés à la réalisation de la couche active 21 sont les fullerènes, notamment le C60, le [6,6]-phényl-C61-butanoate de méthyle ([60]PCBM) et le [6,6]-phényl-C71-butanoate de méthyle ([70]PCBM).

À titre d'exemple, la couche HIL 23 recouvre la couche active 21 et est en contact avec celle-ci.

À titre d'exemple, la couche 23 HIL est :
en un polymère conducteur ou semiconducteur, par exemple organique, par exemple dopé, par exemple un mélange de poly(3,4-éthylènedioxythiophène) (PEDOT) et de poly(styrène sulfonate) de sodium (PSS), connu sous la dénomination PEDOT:PSS, ou le polyaniline ou les polymères connus sous les dénominations commerciales Plexcore OC RG-1100 et Plexcore OC RG-1200 (commercialisés par la société Sigma-Aldrich) ;
en un système hôte/dopant moléculaire comme les produits connus sous la dénomination commerciale NHT-5/NDP-2 et NHT-18/NDP-9 (commercialisés par la société Novaled) ;
en un poly électrolyte, par exemple un fluoropolymère copolymère à base de tétrafluoroéthylène sulfonaté comme le Nafion ;
en un polymère conjugué, comme la polytriarylamine (PTAA) ;
en un composé organique comme le N,N'-diphényl-N,N'-Bis (1-naphtyl)(1,1'-biphènyl)-4,4'-diamine (NPB) ou le N,NT-diphényl-N,N'-(3-méthylphényl)-1,1T-biphènyl-4,4T-diamine (TPD) ; ou
en un mélange de deux ou plus de ces matériaux.

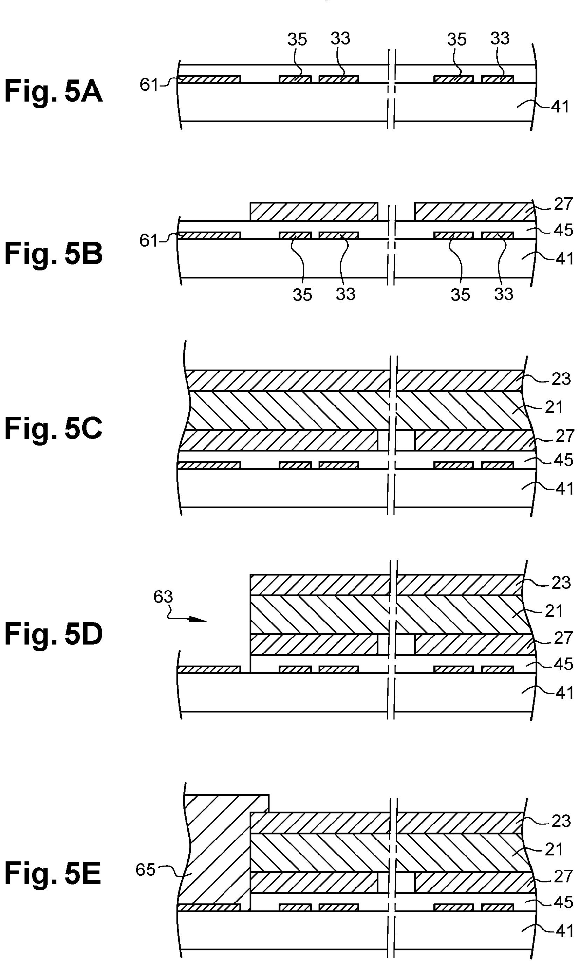

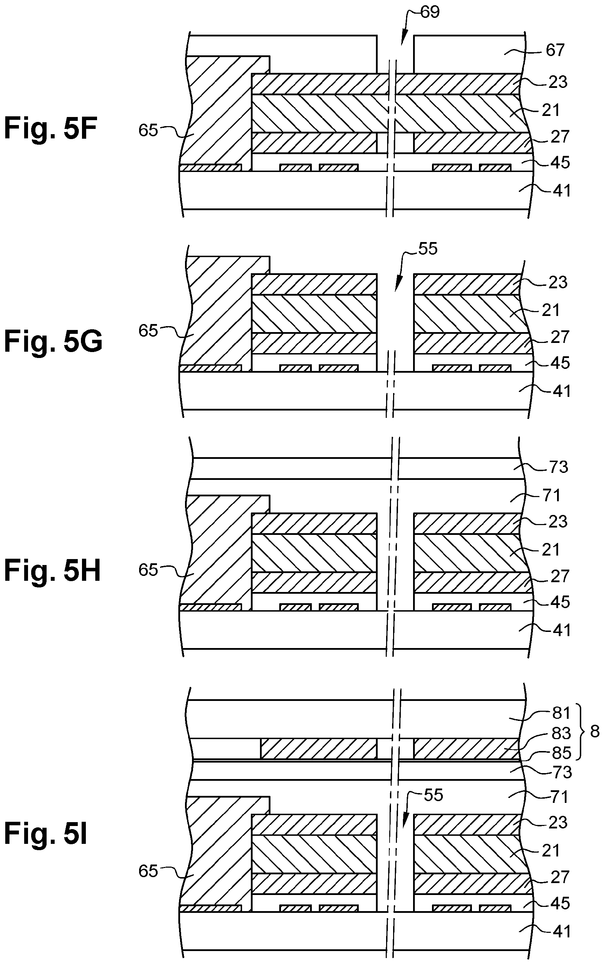

Les figures 5A, 5B, 5C, 5D, 5E, 5F, 5G, 5H et 5I sont des vues en coupe, partielles et schématiques, illustrant des étapes d'un mode de mise en œuvre d'un procédé de fabrication d'un dispositif d'acquisition d'images.

Ces figures représentent schématiquement des exemples de structures obtenues à l'issue d'étapes de fabrication du dispositif d'acquisition d'images. Leur représentation est simplifiée et tous les détails des motifs tels que décrits précédemment ne sont pas représentés. Seuls les motifs utiles à la compréhension du procédé ont été représentés. De plus, d'autres étapes que celles décrites peuvent intervenir dans la fabrication mais n'ont pas été détaillées. En particulier, on suppose que la couche d'ITO de l'électrode inférieure 27 du photodétecteur a le même motif que la couche métallique de cette électrode. On verra ultérieurement que la couche d'ITO peut, à la place, avoir le même motif que la couche active 21. Par ailleurs, la couche EIL 25 n'a pas été représentée dans la mesure où son motif recouvre au moins la couche métallique de l'électrode 27 mais peut s'étendre au-delà.

Les couches susceptibles d'être en des matériaux opaques ou non transparents ont été hachurées dans les figures qui suivent.

La fabrication du dispositif d'acquisition d'image commence (figure 5A) par la fabrication des circuits de lecture 3 dans et/ou sur le substrat 41. Ce substrat est transparent. De préférence, la transparence du matériau constitutif du substrat 41 est d'au moins 80%, plus préférentiellement d'au moins 95%. Par exemple, le substrat est en verre.

Les circuits de lecture 3 sont fabriqués à partir de techniques usuelles de fabrication de circuit électroniques. En fin de fabrication des circuits de lecture, les contacts de source 35 et de drain 33 ainsi que les lignes de grilles 16 et les lignes de sources 14 sont réalisés dans des couches conductrices. En figure 5A, on illustre en partie gauche la présence, en bord de la matrice, d'une barre conductrice 61 de polarisation de la couche d'injection de trous 23 qui constitue l'électrode supérieure du photodétecteur. Cette barre 61 est, par exemple, réalisée dans l'une des couches 42 et 44. Pour simplifier et dans la mesure où ces figures sons schématiques, les lignes de grille et de source n'y figurent pas.

L'ensemble est recouvert pleine plaque d'une couche isolante 45 ayant également pour fonction de planariser la surface du dispositif avant réalisation des photodétecteurs 2.

Pour réaliser les photodétecteurs, on commence (figure 5B) par former la couche d'électrode 27 (au moins sa sous-couche métallique) selon le motif des croix 57 (figures 3 et 4B). Les croix 57 sont isolées les unes des autres par un matériau isolant ou semiconducteur venant des étapes ultérieures.

Puis, on dépose pleine plaque (figure 5C) les couches EIL 25 (non représentée), active 21 et HIL 23. Ces dépôts sont effectués, sous forme liquide, par exemple, par enduction à la filière (« Slot-die coating » en anglais) ou à la tournette (« Spin coating » en anglais).

On grave ensuite (figure 5D) les couches 23, 21, (et 25) au droit de la barre de polarisation 61 de façon à la découvrir (zone 63). Cette gravure est, par exemple, une gravure ionique réactive (RIE, de l'anglais « Reactive Ion Etching »).

On dépose alors (figure 5E) un matériau conducteur 65 pour connecter la couche HIL 23 à la barre 61. Le matériau 65 est, par exemple, le même matériau que celui utilisé pour la couche HIL 23.

Les étapes suivantes illustrées par les figures 5F et 5G consistent à graver l'empilement pour former les zones 55.

On commence (figure 5F) par déposer une couche de résine 67 que l'on ouvre (ouverture 69) par photolithographie selon le motif souhaité pour les zones 55. La résine est par exemple déposée à la tournette.

Puis (figure 5G), on grave les couches 23, 21, 25, et la couche 45, c'est-à-dire jusqu'au substrat transparent 41 à travers le masque de résine 69 et on élimine ensuite ce masque de résine. La gravure est par exemple, une gravure ionique réactive.

On obtient alors une structure de photodétecteurs 2 selon le motif souhaité en fonction du facteur de remplissage surfacique souhaité.

L'ensemble obtenu est ensuite encapsulé (figure 5H). Selon un exemple, on dépose pleine plaque une couche tampon 71 (« buffer layer » en anglais) que l'on recouvre d'une couche atomique 73 (ALD, de l'anglais « Atomique Layer Deposition »). Selon un autre exemple, la couche 71 est une couche de colle et la couche 73 est un film d'encapsulation. La couche 71 remplit les ouvertures 55 et planarise la surface.

Selon un mode de réalisation, le dispositif d'acquisition d'image est alors terminé.

À titre d'exemple, la couche 73 est sensiblement étanche à l'eau et à l'oxygène de l'air de façon à protéger les couches organiques sous-jacentes. La couche 27 peut être en un matériau inorganique, par exemple en oxyde d'aluminium (Al2O3), en oxyde de silicium (SiO2) ou en nitrure de silicium (Si3N4). La couche 73 peut avoir une épaisseur comprise entre 2 et 200 nm. La couche 73 est par exemple formée par dépôt de couches atomiques successives (ALD, de l'anglais « Atomic Layer Deposition »), par dépôt physique en phase vapeur (PVD, de l'anglais « Physical Vapor Déposition ») ou par dépôt chimique en phase vapeur (CVD, de l'anglais « Chemical Vapor Deposition »), par exemple par dépôt chimique en phase vapeur assisté par plasma (PECVD, de l'anglais pour « Plasma-Enhanced Chemical Vapor Deposition »).

Selon un autre mode de réalisation (figure 5I), le dispositif est associé à un filtre optique 8. Ce filtre est, par exemple réalisé séparément à partir d'une plaque ou substrat 81 en verre sur lequel est déposée par laminage (en anglais «Lamination » ou par dépôt sélectif d'une résine noire 83 selon le motif choisi. Par exemple, les régions de résine noires sont localisées pour se retrouver à l'aplomb des zones opaques du dispositif d'acquisition. Le filtre 8, réalisé séparément, est ensuite rapporté sur la structure issue de la figure 5G, avec interposition d'une couche d'adhésif 85 pour obtenir le dispositif illustré en figure 5I.

Ce mode de mise en œuvre est particulièrement adapté au cas où le filtre optique est réalisé séparément. Il permet en particulier de standardiser la fabrication d'un même dispositif d'acquisition d'images (des figures 5A à 5H) pour des applications avec des filtres de nature différentes ou avec et sans filtre.

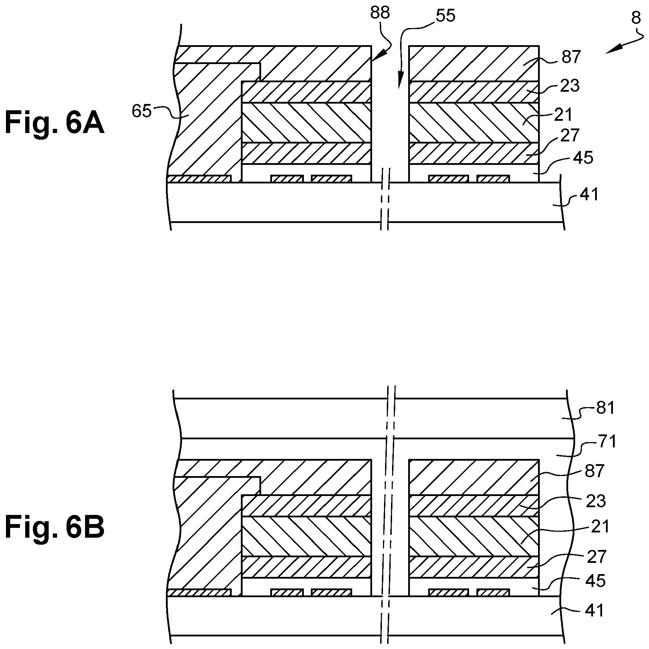

Les figures 6A et 6B sont des vues en coupe, partielles et schématiques, illustrant des étapes d'un autre mode de mise en œuvre d'un procédé de fabrication d'un dispositif d'acquisition d'images.

Ce mode de mise en œuvre reprend les étapes décrites précédemment en relation avec les figures 5A à 5E qui ne seront pas redécrites.

À partir de la structure issue de la figure 5E, on réalise ici le filtre optique directement sous la forme du masque de gravure des couches 23, 21 et 25.

On commence (figure 6A) par déposer une couche de résine noire 67 que l'on ouvre (ouverture 89) par photolithographie selon le motif souhaité pour les zones 55. La résine est par exemple déposée à la tournette. La résine 87 est choisie pour être transparente au rayonnement infrarouge et opaque dans le visible. Le filtre 8 est alors utilisé comme masque de gravure jusqu'au substrat transparent 41.

L'ensemble obtenu est ensuite par exemple encapsulé de la manière décrire en relation avec la figure 5H (couches 71 et 73.

Selon un autre exemple, un fois la couche tampon 71 ou de colle déposée pour remplir les ouvertures 55 et planariser la surface, on rapporte une plaque de verre 81.

Le mode de mise en œuvre des figures 6A et 6B est plus particulièrement destiné aux applications avec filtre et permet la réalisation de l'ensemble du dispositif dans un même processus. Un avantage est que cela évite les défauts d'alignement éventuels lorsque le filtre 8 du mode de mise en œuvre de la figure 5I est rapporté sur la structure de la figure 5H.

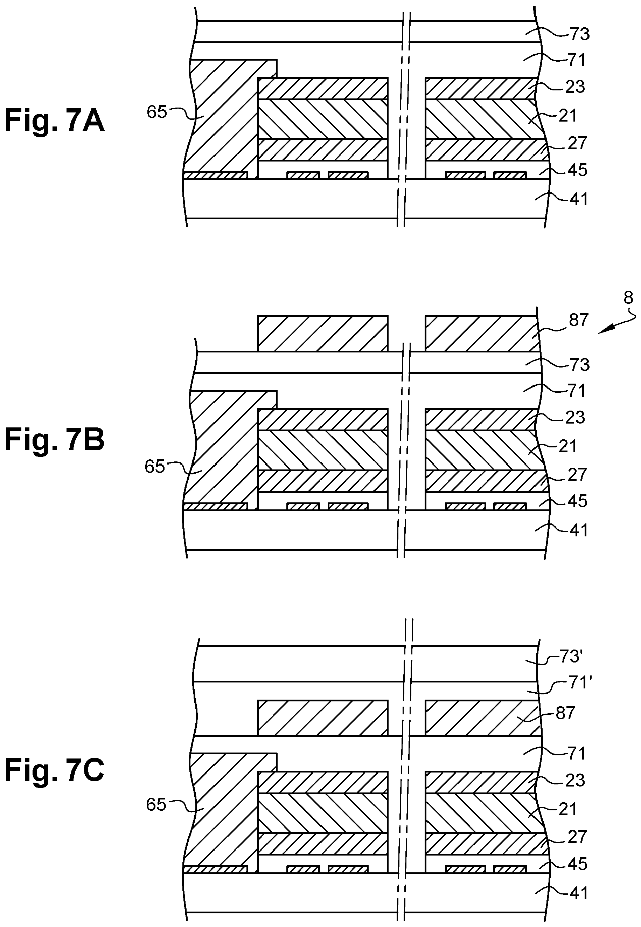

Les figures 7A, 7B et 7C sont des vues en coupe, partielles et schématiques, illustrant des étapes d'un autre mode de mise en œuvre d'un procédé de fabrication d'un dispositif d'acquisition d'images.

Ce mode de mise en œuvre reprend les étapes décrites précédemment en relation avec les figures 5A à 5G qui ne seront pas redécrites.

À partir de la structure issue de la figure 5G, on dépose (figure 7A) pleine plaque une couche tampon 71 (« buffer layer » en anglais) qui comble les ouvertures 55 et planarise la surface. La couche 71 est, optionnellement, recouverte d'une couche atomique 73 (ALD, de l'anglais « Atomique Layer Deposition »).

Puis (figure 7B), on réalise un filtre optique par développement d'une couche de résine noire 87.

L'ensemble obtenu est ensuite encapsulé (figure 7C). Selon un exemple, on dépose pleine plaque une deuxième couche tampon 71' (« buffer layer » en anglais) que l'on recouvre d'une couche atomique 73' (ALD, de l'anglais « Atomique Layer Deposition »). Selon un autre exemple, la couche 71' est une couche de colle et la couche 73' est un film d'encapsulation. Le matériau de la couche 71 comble les espace entre les blocs de résine noire et planarise la surface. La figure 7C illustre par ailleurs la variante sans couche 73 sous la couche 87.

La figure 8 est une vue en coupe, partielle et schématique, illustrant une variante de réalisation d'un dispositif d'acquisition d'images.

Ce mode de mise en œuvre reprend les étapes décrites précédemment en relation avec les figures 5A à 5G qui ne seront pas redécrites.

À partir de la structure issue de la figure 5G, on dépose pleine plaque une couche conductrice ou semiconductrice transparente 91 que l'on grave selon le motif de quadrillage de la couche HIL 23 et qui rejoint la couche 65. Cela permet d'améliorer la conduction de l'électrode supérieure 23 des photodétecteurs. La couche 91 peut remplir les ouvertures 55. L'isolation entre les croix 57 est assurée par la couche d'OSC qui est alors gravée selon un motif plus large que la couche 27, ou en revêtant les flancs des croix d'une couche isolante distincte. Cette couche isolant verticalement les flancs des croix peut être présente dans les autres modes de réalisation.

Le matériau de la couche 91 est, par exemple, dans le même matériau que la couche HIL 23.

Les étapes suivantes peuvent reprendre l'un quelconque des modes de mise en œuvre décrits précédemment (couches 71 et/ou 73, figure 5H, couche de résine noire 87 (figure 6A), couche 71 et ou 73, figure 7A).

La figure 9 est une vue de dessus, partielle et schématique, illustrant une autre variante de réalisation d'un dispositif d'acquisition d'images.

Cette variante consiste, par rapport au mode de réalisation illustré en relation avec la figure 4B, en un motif différent pour la couche d'ITO 27' de l'électrode inférieure 27, intercalée entre la couche métallique 27" de cette électrode inférieure 27 et la couche active 21 (plus précisément entre la couche 27" et la couche EIL 25).

Selon cette variante, on conserve un motif en croix 57 et, de préférence les zones 53, pour la couche métallique d'électrode 27", mais on agrandit les motifs réalisés dans la couche d'ITO 27' et la couche active 21 (ainsi que la couche EIL 25 qui est gravée en même temps) de sorte que la couche active 21 et la couche d'ITO 27" occupent une surface plus importante. Cela revient à conférer à la couche active 21, la couche EIL et la couche d'ITO 27', un motif en croix 57 associé à un rectangle 93 qui s'étend pour réduire la surface des zones transparentes 55.

La réalisation de la variante de la figure 9 requiert cependant de graver les couches de l'empilement constitutif des photodétecteurs séparément les unes des autres, au moins en trois étapes (couches 27", couches 27', 25 et 21, couche 23) .

Cette variante permet d'ajuster la transparence du dispositif en ne jouant que sur les surfaces occupées par les couches d'ITO 27" et active 21 (OSC).

Cette variante est compatible avec une réalisation dans laquelle l'électrode 27 est exclusivement composée d'ITO.

La figure 9 illustre également un exemple de dimensions avec un pas de 40 µm. Les ranches des croix 57 ont, selon cet exemple, une largeur de 10 µm et les zones 53 ont des dimensions de 10 µm par 10 µm.

On notera que la variante de la figure 9 n'est pas compatible avec celle de la figure 8.

Un avantage des modes de réalisation et de mise en oeuvre décrits est qu'ils permettent d'améliorer la transparence de dispositif d'acquisition d'images.

Un autre avantage des modes de réalisation et de mise en oeuvre décrits est qu'ils sont compatibles avec les techniques usuelles de fabrication de circuits de lecture et de photodétecteurs organiques.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif d'acquisition d'images (1), dans lequel des photodétecteurs organiques (2) ont un motif suivant des lignes (14, 16) d'interconnexion de circuits de lecture (3) et des premières électrodes (27) des photodétecteurs (2) ont un motif en croix (57) dont deux branches sont respectivement à l'aplomb des lignes (14, 16) interconnectant les circuits de lecture (3).

2. Dispositif selon la revendication 1, dans lequel une couche d'injection de trous (23) commune aux photodétecteurs (2) a un motif de quadrillage à l'aplomb des lignes (14, 16) interconnectant les circuits de lecture (3).

3. Dispositif selon la revendication 2, dans lequel une couche active (21) de chaque photodétecteur a le motif de quadrillage de la couche d'injection de trous (23).

4. Dispositif selon l'une quelconque des revendications 1 à 3, dans lequel une couche active (21) de chaque photodétecteur a le motif en croix (57) de sa première électrode (27).

5. Dispositif selon la revendication 3 ou 4, dans lequel la couche active (21) et la première électrode de chaque photodétecteur s'étendent (93) au-delà dudit motif.

6. Dispositif selon l'une quelconque des revendications 1 à 5, dans lequel chaque circuit de lecture (3) comporte un transistor, les lignes d'interconnexion correspondant à des lignes (14, 16) interconnectant respectivement les sources (35) des transistors selon une première direction et les grilles (37) des transistors selon une deuxième direction.

7. Dispositif selon la revendication 5, dans lequel le motif selon lequel sont réalisés les photodétecteurs (2) est également à l'aplomb de contacts de drain (33) des transistors des circuits de lecture (3).

8. Dispositif selon l'une quelconque des revendications 1 à 6, dans lequel la surface masquée par la couche active (21) des photodétecteurs (2) représente, pour chaque pixel, moins de 50%, de préférence moins de 30% de la surface du pixel.

9. Procédé de fabrication d'un dispositif d'acquisition d'images (1) comprenant les étapes suivantes :
formation d'une matrice de circuits de lecture (3) dont des transistors sont interconnectés en lignes de sources (14) dans une première direction et en lignes de grilles (16) dans une deuxième direction ;
dépôt, à partir de la matrice de circuits de lecture, d'un empilement comportant au moins :
une couche de premières électrodes (27) ;
une couche active organique (21) ; et
une couche injectrice de trous (23)
gravure des couches de l'empilement séparément ou simultanément selon un motif suivant au moins des lignes (14, 16) d'interconnexion de circuits de lecture (3), les premières électrodes (27) ayant un motif en croix (57) dont deux branches sont respectivement à l'aplomb des lignes (14, 16) interconnectant les circuits de lecture (3).

10. Procédé selon la revendication 9, dans lequel la gravure des couches de l'empilement est telle que la surface masquée de façon cumulative par la couche d'électrodes (27) et la couche active (21) représente, pour chaque pixel, moins de 50%, de préférence moins de 30% de la surface du pixel.

11. Procédé selon la revendication 9 ou 10, dans lequel la couche active (21) est gravée en même temps que la couche injectrice de trous (23).

12. Procédé selon l'une quelconque des revendications 9 à 11, dans lequel un filtre optique (8) est rapporté sur l'empilement.

13. Procédé selon l'une quelconque des revendications 9 à 12, dans lequel les couches de l'empilement recouvrent en outre des contacts de drain (33) des transistors des circuits de lecture (3).

14. Procédé selon l'une quelconque des revendications 9 à 13, dans lequel les étapes sont adaptées à la fabrication d'un dispositif selon l'une quelconque des revendications 1 à 8.
